# EUROPEAN PATENT SPECIFICATION

(11) **EP 3 840 023 B1**
(45) Date of publication and mention of the grant of the patent: **19.10.2022**
(21) Application number: 19217353.2
(22) Date of filing: 18.12.2019
(51) Int. Cl.: H01L 21/673, H01L 21/67

(54) **IMPROVED DEVICE FOR DRYING SEMICONDUCTOR SUBSTRATES**
VERBESSERTE VORRICHTUNG ZUM TROCKNEN VON HALBLEITERSUBSTRATEN
DISPOSITIF AMÉLIORÉ POUR LE SÉCHAGE DE SUBSTRATS SEMI-CONDUCTEURS

(43) Date of publication of application: 23.06.2021
(73) Proprietor: Siltronic AG, 81677 München (DE)
(72) Inventor: Geißler, Sebastian, 09618 Brand-Erbisdorf (DE); Rothenaicher, Simon, 84567 Erlbach (DE)

(56) References cited:
- US-A1- 2003 145 874
- US-A1- 2007 157 951
- US-A1- 2010 078 867
- US-A1- 2016 201 986
- US-B2- 6 497 785

## Description

The object of the invention is a device for use in drying disc-shaped semiconductor substrates.

### Background of the Invention

The invention relates to a device being used to treat semiconductor wafers, in which the latter are immersed for some time in a bath containing a liquid and are then taken therefrom so slowly that practically the whole quantity of liquid remains in the bath.

### Prior Art / Problems

A method of this kind may be used, for example, in the manufacture of electric circuits on all kinds of substrates, such as, for example, integrated circuits on semiconductor wafers (for example of silicon), drives for liquid crystal displays on transparent plates of glass or quartz or circuits on plates of synthetic material (circuit boards). The method may also be used in the manufacture of shadow masks for television picture tubes or in the manufacture of CD or VLP records. In all these cases, the substrates are immersed many times for some time in a bath containing a liquid, for example in galvanic baths for deposition of metals, in etching baths for etching patterns into metal layers or into semiconductor material, in development baths for developing exposed photo lacquer layers and in rinsing baths for cleaning the substrates. After treatment in the liquid baths, the substrates are taken from the liquid and are dried. The substrates can be taken from the liquid in that they are lifted or withdrawn from the liquid, but of course also in that the liquid is caused to flow out of the bath.

While being taken from the bath the semiconductor wafer reside on a device is used to hold the semiconductor wafer in place. During this process, the problem can arise that residues of liquid remain at the edge of the substrate. This can lead to unwanted particles on the edge of the substrate, which are later on effecting the quality of the semiconductor wafer.

The physical effect utilized thereby are described in CN1045539 A (EP 03 855 36 A1), as is an apparatus which is to some extent suitable for conduction of the method.

A device and a method to improve the quality of cleaning in respect to remaining particles of the semiconductor wafer is given in DE 10 2014 207 266 A1. However, using this there are still particles left that reduce the quality of the semiconductor wafers.

Document US 2007/157951 A1 discloses at least a system, and associated method, for processing microfeature workpieces, said system comprising a workpiece mover designed for supporting a batch of said workpieces.

It is an object of the present invention to improve said device, and more particularly to show how the number of particles, which are found on the dried substrates, can be reduced by using this device.

### Description of the Invention

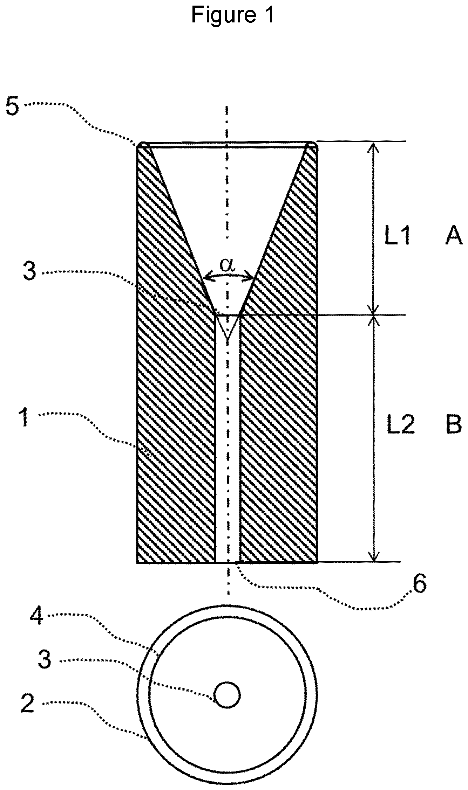

Figure 1 shows a device (disc holder) for the present invention.

The device comprises an elongated body (1) having a top surface, a bottom surface and a circumferential surface.

A hole in the top surface forms a channel (6) which extends to a lower drainage part (B) of the elongated body (1).

The hole in the top surface is chamfered and has depth (L1) and a conical angle (α). The depth (L1) defines a funnel region of the device. An edge is formed between the chamfer and the top surface, which is preferably edge-rounded (5). This forms a conical recess suitable a disc shaped substrate to rest on.

The said conical angle (α) is preferably not more than 60° and not less than 10° and the depth (L1) is preferably not more than 15 mm and not less than 7 mm.

Preferably, the device is made from ceramic filled polyetheretherketone (CFM PEEK). More preferably, the diameter of a channel is not less than 0.5 mm and not more than 3mm. Preferably the diameter is not less than 0.8mm and not more than 1.2mm. More preferably, the length of the channel (L2) is not less than 5 mm and not more than 20 mm.

### List of reference numerals employed

- A: Funnel region of the elongated body
- B: Drainage part of the elongated body
- L1: Height of the wedge formed on top of the elongated body
- L2: Height of the drainage part
- 1: Elongated body
- 2: Diameter of the elongated body.
- 3: Hole
- 4: Chamfering diameter of the elongated body.
- 5: Rounded edge formed between the chamfer and the top surface.
- 6: Channel extending a hole in the top surface to the lower surface.
- α: Opening angle of the wedge, angle between two surfaces and an upper edge

## Claims

1. Device for drying disc-shaped substrates comprising
an elongated body (1) having a top surface, a bottom surface and a circumferential surface,
comprising a hole in the top surface forming a channel (6) which extends to a lower drainage part (B) of the elongated body and having a depth (L1) and being chamfered having a conical angle (α) forming an edge between the channel and top surface and forming a conical recess suitable for resting a disc shaped substrate,
wherein the conical angle is more than 10° and less than 30° and that the depth (L1) is more than 6 mm and less than 12 mm

2. Device according to claim 1 **characterized in that**
the material used for the device comprises ceramic filled polyetheretherketone (CFM PEEK).

3. Device according to any of claim 1 or claim 2, **characterized in that**
the edge between chamfer and top surface is rounded with a radius not more than 0.1 mm and not less than 1 mm.

4. Device according to any of claims 1 to 3, **characterized in that**
the diameter of the channel is not less than 0.5mm and not more than 3mm, preferably not less than 0.8mm and not more than 1.2mm.

5. Device according to any of claims 1 to 4, **characterized in that**
the length of the channel (L2) is not less than 30 mm.

6. Method of drying a disc-shaped substrate using a device according to any of claims 1 to 5.

## Patentansprüche

1. Vorrichtung zum Trocknen scheibenförmiger Substrate, die
einen länglichen Körper (1) mit einer oberen Fläche, einer unteren Fläche und
einer Umfangsfläche umfasst
, der
ein Loch in der oberen Fläche umfasst, das einen Kanal (6) bildet
, der sich zu einem unteren Entwässerungsteil (B) des länglichen Körpers erstreckt und
mit einer Abschrägungstiefe (L1) und einem Abschrägungswinkel (a) abgeschrägt ist, die eine Kante zwischen Abschrägung und oberer Fläche
bilden und eine konische Aussparung bilden, die zum Auflegen eines scheibenförmigen Substrats geeignet ist,
**dadurch gekennzeichnet, dass** der Abfasungswinkel mehr als 10° und weniger als 30°
beträgt und
dass die Abfasungstiefe (L1) mehr als 6 mm und weniger als 12 mm beträgt.

2. Vorrichtung nach Anspruch 1, **dadurch gekennzeichnet, dass**
das für die Vorrichtung verwendete Material keramikgefülltes Polyetheretherketon (CFM PEEK) umfasst.

3. Vorrichtung nach einem der Ansprüche 1 oder 2, **dadurch gekennzeichnet, dass**
die Kante zwischen Fase und Oberseite mit einem Radius von nicht mehr als 0,1 mm und nicht weniger als 1 mm abgerundet ist.

4. Vorrichtung nach einem der Ansprüche 1 bis 3, **dadurch gekennzeichnet, dass**
der Durchmesser des Kanals nicht weniger als 0,5 mm und nicht mehr als 3 mm, vorzugsweise nicht weniger als 0,8 mm und nicht mehr als 1,2 mm beträgt.

5. Vorrichtung nach einem der Ansprüche 1 bis 4, **dadurch gekennzeichnet, dass**
die Länge des Kanals (L2) nicht weniger als 30 mm
beträgt.

6. Verfahren zum Trocknen eines scheibenförmigen Substrats unter Verwendung
einer Vorrichtung nach einem der Ansprüche 1 bis 5.

## Revendications

1. Dispositif de séchage de substrats en forme de disque, comprenant
un corps allongé (1) ayant une surface supérieure, une surface inférieure et une surface périphérique ,
comprenant un trou dans la surface supérieure formant un canal (6)
qui s'étend
vers une partie inférieure de drainage (B) du corps allongé et qui
est chanfreiné avec une profondeur de chanfrein (L1) et un angle de chanfrein (a), formant
une arête entre le biseau et la surface supérieure et formant un évidement conique adapté à la mise en place d'un substrat en forme de disque,
**caractérisé en ce que** l'angle de biseau
est
supérieur à 10° et inférieur à 30°
et
**en ce que** la profondeur de biseau (L1)
est
supérieure à 6 mm et inférieure à 12 mm

2. Dispositif selon la revendication 1, **caractérisé en ce que**
le matériau utilisé
pour le dispositif
comprend du polyétheréthercétone chargé de céramique (CFM PEEK).

3. Dispositif selon l'une des revendications 1 ou 2, **caractérisé en ce que**
l'arête entre le chanfrein et la face supérieure
est arrondie
avec un rayon qui n'est pas supérieur
à 0,1 mm et pas inférieur à 1 mm

4. Dispositif selon l'une des revendications 1 à 3, **caractérisé en ce que**
le diamètre du canal n'
est
pas inférieur à 0,5 mm et pas supérieur à 3 mm, de préférence pas inférieur à 0,8 mm et pas supérieur à 1,2 mm

5. Dispositif selon l'une quelconque des revendications 1 à 4, **caractérisé en ce que**
la longueur du canal (L2) n'
est
pas inférieure à 30 mm.

6. Procédé de séchage d'un substrat en forme de disque utilisant un dispositif selon l'une quelconque des revendications 1 à 5.
